# EUROPEAN PATENT APPLICATION

(11) **EP 1 703 335 A1**
(43) Date of publication of application: **20.09.2006**
(21) Application number: 06005184.4
(22) Date of filing: 14.03.2006
(51) Int. Cl.: G03G 15/00

(54) **Operation panel, manufacturing method thereof, and electronic control apparatus**

(30) Priority: 14.03.2005 JP 2005071793; 05.01.2006 JP 2006000812
(71) Applicant: SEIKO EPSON CORPORATION, Shinjuku-ku, Tokyo 163-0811 (JP)
(72) Inventor: Kimura, Kenichi, Suwa-shi Nagano-ken 392-8502 (JP)
(74) Representative: HOFFMANN EITLE

(57) **Abstract**

An operation panel 40 is prepared in the following manner. First, components are mounted in mounting holes 14a, 14c to 14e, and 14g to 14o of a base member 12, and other mounting holes 14b, 14f, 14p, and 14q are left vacant without mounting components therein. Next, a plate member 26 that is provided with exposing holes 20a, 20c to 20e, 20g to 20o to expose components outside at positions opposed to the mounting holes 14a, 14c to 14e, and 14g to 14o in which the components have been mounted and is provided with no expos'ing holes at positions opposed to vacant mounting holes 14b, 14f, 14p, and 14q is prepared. The plate member 26 is integrated with the base member 12 by covering a component mounting surface 14 with the plate member 26 and fitting respective hooks 24 into respective hook latching holes 16.

## Description

### Technical Field

The present invention relates to an operation panel fitted to an electronic control apparatus, a manufacturing method of the same, and an electronic control apparatus.

### Background Art

Conventionally, operation panels fitted to electronic control apparatuses such as printers and faxes have been known. Although such operation panels are often provided with a large number of switches, some users may use only specific switches of these. Therefore, in Japanese Published Unexamined Patent Application No. 2003-298791, a mask cover has been proposed, in which cut-away work parts are provided at the positions corresponding to respective switches, and the cut-away work parts are cut away only at the positions corresponding to switches the user uses to expose the switches.

### Disclosure of the Invention

The technique disclosed in Japanese Published unexamined PatentApplicationNo. 2003-298791 is on the premise that a large number of switches are provided on an operation panel, and only switches the user uses are exposed. However, there is a problem in that a larger number of switches than necessary have been provided on the operation panel in the first place. Accordingly, although it is preferable to provide a wide variation of operation panels such as operation panels with a few switches and operation panels with many switches to allow a user to select an operation panel he/she wants, there is a problem in ballooning manufacturing costs since multiple types of operation panels must be prepared in that case.

The present invention has been made to solve such a problem, and an object thereof is to provide an operation panel that allows manufacturing multiple types at a low cost and a manufacturing method thereof. Moreover, an object is to provide an electronic control apparatus having such an operation panel.

In order to achieve the above-described objects, the present invention has employed the following means.

The present invention is directed to a first operation panel that is used when operating an electronic control apparatus, and includes: a base member that has first component mounting holes capable of mounting components to be exposed on an outer surface of the panel out of components used for a setting or operation of a basic function and second component mounting holes capable of mounting components to be exposed on the outer surface of the panel out of components used for a setting or operation of an optional function added to the basic function; and a plate member that is integrated with the base member so as to cover an operating surface side of the base member and is provided with exposing holes at least at positions opposed to the first component mounting holes.

In the first operation panel according to the present invention, thebasememberhas the first component mounting holes capable of mounting components to be exposed on an outer surface of the panel out of components used for a setting or operation of a basic function and the second component mounting holes capable of mounting components to be exposed on the outer surface of the panel out of components used for a setting or operation of an optional function added to the basic function. It is possible to mount components in both the first and second component mounting holes as well as to mount components in only the first component mounting holes. In case where components have been mounted in both first and second component mounting holes of the base member, the base member can be integrated with the plate member that is provided with exposing holes both at positions opposed to the first component mounting holes and at positions opposed to the second component mounting holes. In case where components have been mounted in only the first component mounting holes of the base member, on the other hand, the base member can be integrated with the plate member that is provided with exposing holes only at positions opposed to the first component mounting holes with the base member. As such, it is sufficient to exchange only the plate member while using the base member in common when manufacturing multiple types of operation panels, and thus manufacturing costs can be kept low.

Here, as the "basic function" and the "optional function, it may be possible to provide the basic function as a print function, and the optional function as at least one of a copy function, a scanner function, and a facsimile function, otherwise to provide the basic function as a print function, a copy function, and a scanner function, and the optional function as a facsimile function, or provide the basic function as a monochrome printing function, and the optional function as a color printing function.

In the first operation panel of the invention, the plate member may be selected from a basic function-compliant plate member having exposing holes only at positions opposed to the first component mounting holes and an optional function-compliant plate member having exposing holes both at positions opposed to the first component mounting holes and at positions opposed to the second component mounting holes. The selection either the basic function-compliant plate or the optional function-compliant plate allows for manufacture of multiple types of operation panels.

The present invention is also directed to a second operation panel that is used when operating an electronic control apparatus, and includes: a base member that has a component mounting surface provided with a plurality of mounting holes for mounting all types of components, where components have been mounted in some of the plurality of mounting holes; and a plate member that is integrated with the base member so as to cover the component mounting surface and is provided with exposing holes to expose the components outside at positions opposed to mounting holes in which the components have been mounted.

In the second operation panel according to the present invention, the base member has the plurality of mounting holes for mounting all types of components are. It is possible to mount all types of components as well as tomount only some of all types of components. In case where components have been mounted in all mounting holes of the base member, the base member is integrated with the plate member that is provided with exposingholes atpositions opposed to all mounting holes. In case where components have been mounted in some of the mounting holes of the base member, on the other hand, the base member is integrated with the plate member that is provided with exposing holes at positions opposed to some of the component mounting holes. As such, it is sufficient to exchange only the plate member while using the base member in common when manufacturing multiple types of operation panels, and thus manufacturing costs can be kept low.

Here, the "all types of components" mean all types of components that are used to realize a plurality of predetermined functions and exposed on the outer surface of the panel. Moreover, the "component mounting surface" means a surface of the base member where a plurality of mounting holes for mounting components are opened.

In the second operation panel of the invention, the plate member may be selected from an all component-compliant plate provided with the exposing holes at positions opposed to each of the mounting holes andapartial component-compliant plate provided with the exposing holes at positions opposed to some of the plurality of mounting holes. The selection either the basic function-compliant plate or the optional function-compliant plate allows for manufacture of multiple types of operation panels.

In the first and second operation panels of the invention, the plate member may be formed in a plate-like shape, and the base member may be thicker than the plate member. In this case, it is relatively easy even to prepare multiple types since the plate member has a plate-like shape, whereas since the base member is thick, it is highly significant to provide it as a common component as the cost easily rises when multiple types are prepared. This is more prominent in the case of molding by a metal mold.

In the first and second operation panels of the invention, the base member may have cutout grooves at peripheral portions, and the plate member may have fitting projections that are fitted into the cutout grooves when being integrated with the base member. This structure prevents the plate member from coming off from the base member by holding down the plate member by holding members from the upside of the fitting projections when the operation panel of invention is fitted to an electronic control apparatus.

In the first and second operation panels of the invention, information concerning components exposed from the exposing holes may be printed in the vicinity of the exposing holes of the plate member. Thus, a user is allowed to easily know the information concerning the exposed components without depending on an instruction manual or the like. When the plate member is formed in a plate-like shape, such printing of information can be easily carried out. Here, the information concerning components is information that represents, for example, names and functions of components, and it may be letters as well as symbols/graphics that mean something. In the case of letters, it may be carried out in various languages.

The present invention is also directed to an electronic control apparatus including any of theabove-describedoperationpanels of the invention. As for the operation panel of the invention, it is sufficient to exchange only the plate member while using the base member in common, so as to manufacture multiple types of operation panels, keeping manufacturing costs low. As for the electronic control apparatus employing the operation panel, it is accordingly possible to keep manufacturing cost low, and thus the cost of the electronic control apparatus as a whole can be lowered. The electronic control apparatus, though not particularly limited, may be a printer, a fax, a copier, a scanner, and a multifunction device provided with functions of two or more of these.

The present invention is further directed to a first manufacturing method for an operation panel to be fitted to a chassis of an electronic control apparatus. The first manufacturing method includes the steps of: (a) preparing a base member that has first component mounting holes capable of mounting components to be exposed on an outer surface of the panel out of components used for a setting or operation of a basic function and second component mounting holes capable of mounting components to be exposed on the outer surface of the panel out of components used for a setting or operation of an optional function added to the basic function, and mounting components in only the first component mounting holes or mounting components in both the first and second component mounting holes; and (b) selecting either plate member according to the components mounted in the step (a) of a basic function-compliant plate member having exposing holes only at positions opposed to the first component mounting holes and an optional functian-compliant plate member having exposing holes both at positions opposed to the first component mounting holes and at the positions opposed to the second component mounting holes, and covering an operating surface side of the base member with the selected plate member so as to integrate the plate member with the base member.

The first manufacturing method for an operation panel of the invention prepares the base member that has the first component mounting holes capable of mounting components to be exposed on an outer surface of the panel out of components used for a setting or operation of a basic function and the second component mounting holes capable of mounting components to be exposed on the outer surface of the panel out of components used for a setting or operation of an optional function added to the basic function. It is possible to mount components in both the first and second component mounting holes as well as to mount components in only the first component mounting holes. In case where components have been mounted in both first and second component mounting holes of the base member, the base member can be integrated with the plate member that is provided with exposing holes both at positions opposed to the first component mounting holes and at positions opposed to the second component mounting holes. In case where components have been mounted in only the first component mounting holes of the base member, on the other hand, the base member can be integrated with the plate member that is provided with exposing holes only at positions opposed to the first component mounting holes with the base member. As such, it is sufficient to exchange only the plate member while using the base member in common when manufacturing multiple types of operation panels, and thus manufacturing costs can be kept low.

The present invention is further directed to a second manufacturing method for an operation panel to be fitted to a chassis of an electronic control apparatus. The second manufacturing method includes the steps of: (a) preparing a base member that has a component mounting surf ace provided wi th a plural ity of mounting holes f or mounting all types of components, and mounting components in all or some of the plurality of mounting holes; and (b) preparing a plate member that is provided with exposing holes to expose the components outside at positions opposed to mounting holes in which the components have been mounted and is provided with no exposing holes at positions opposed to vacant mounting holes, and covering the component mounting surface with the plate member so as to integrate the plate member with the base member.

The second manufacturing method for an operation panel of the invention prepares the base member that has the plurality of mounting holes for mounting all types of components are. It is possible to mount all types of components as well as to mount only some of all types of components. In case where components have been mounted in all mounting holes of the base member, the base member is integrated with the plate member that is provided with exposing holes at positions opposed to all mounting holes. In case where components have been mounted in some of the mounting holes of the base member, on the other hand, the base member is integrated with the plate member that is provided with exposing holes at positions opposed to some of the component , mounting holes. As such, it is sufficient to exchange only the plate member while using the base member in common when manufacturing multiple types of operation panels, and thus manufacturing costs can be kept low.

### Brief Description of the Drawings

Fig. 1 is a schematic perspective view of a full-featured multifunction device.
Fig. 2 is a perspective assembly drawing of an operation panel for a full-featured multifunction device.
Figs. 3 are sectional views showing conditions before and after hooks are inserted into hook latching holes.
Fig. 4 is a schematic perspective view of a multifunction device with a simplified function.
Fig. 5 is a perspective assembly drawing of an operation panel for a multifunction device with a simplified function.

### Detailed Description of the Invention

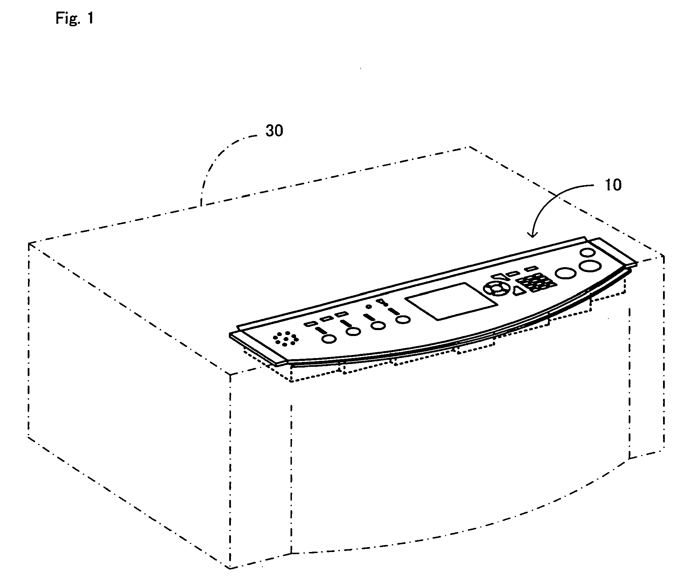

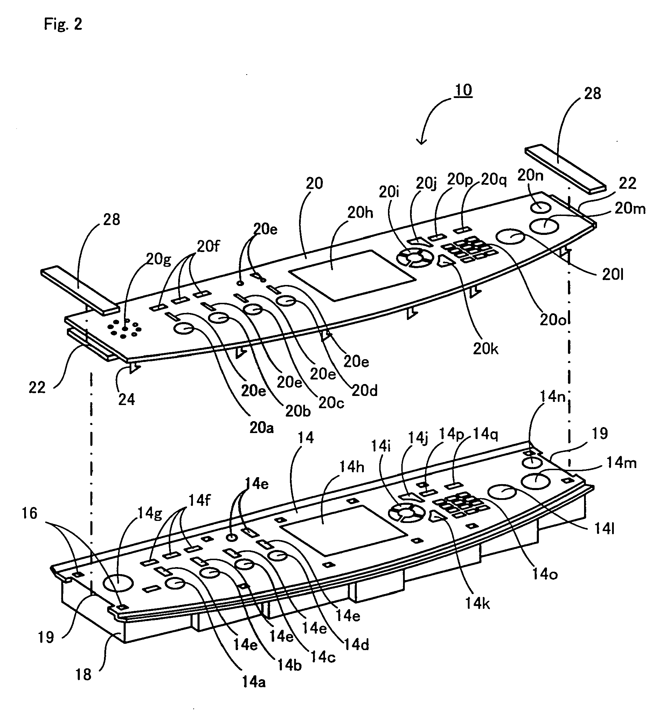

First, a full-featured multifunction device 30 will be described. Fig. 1 is a schematic perspective view of the multifunction device 30, and Fig. 2 is a perspective assembly drawing of an operation panel 10 for the multifunction device 30. The operation panel 10 is, as shown in Fig. 1, to be fitted to the multifunction device 30 provided with a plurality of predetermined functions as a scanner, a printer, a copier, and a fax. The operation panel 10 is formed by integrating a resin-made thick base member 12 molded by a metal mold with a resin-made plate-like thin-walled plate member 20 similarly molded by a metal mold, as shown in Fig. 2.

The base member 12 is provided with a plurality of holes 14a to 14q for mounting all types of components used to realize the functions described above and exposed on the outer surface of the panel. A component mounting surface 14 of the base member 12 is a surface where the respective mounting holes 14a to 14q are opened and a surface on the side to be operated by a user. The component mounting surface 14 includes, on the left side of the surface, a copy button mounting hole 14a for mounting a copy button that is depressed to execute copying, a fax button mounting hole 14b for mounting a faxbutton that is depressed to send a fax, a scanner button mounting hole 14c for mounting a scanner button that is depressed to scan an image with a scanner, and a setting button mounting hole 14d for mounting a various setting button which is depressed to perform various setting operations, as well as lamp mounting holes 14e for mounting various indicator lamps, dial mounting holes 14f for mounting one-touch dials, and a speaker mounting hole 14g for mounting a speaker. The component mounting surface 14 also includes, at about the center of the surface, a display mounting hole 14h for mounting a display that is capable of displaying various types of information. The component mounting surface 14 further includes, on the right side of the surface, an up, down, left, right key mounting hole 14i for mounting up, down, left, and right keys for selecting contents displayed on the display, an extension button mounting hole 14j for mounting an extension button that is depressed to extend a menu displayed on the display, a reset button mounting hole 14k for mounting a reset button that is depressed to reset set contents, a monochrome start button mounting hole 141 for mounting a monochrome start button that is depressed to instruct to start operation in monochrome, a color start button mounting hole 14m for mounting a color start button that is depressed to instruct to start operation in color, and a stop button mounting hole 14n for mounting a stop button that is depressed to instruct to stop operation, as well as a numeric keypad mounting hole 14o for mounting a numeric keypad, an abbreviation button mounting hole 14p for mounting an abbreviation button that is depressed to call up abbreviated dialing numbers of the fax, and a redial button mounting hole 14q for mounting a redial button that is depressed to instruct the fax to redial. The component mounting surface 14 has a plurality of hook latching holes 16 that are formed along the circumference of the surface. Here, components are mounted in all of the respective mounting holes 14a to 14q. Although not illustrated, these components are fixed to the rear side of the component mounting surface 14 and are exposed from the respective mounting holes 14a to 14q.

On the rear side of the component mounting surface of the base member 12, a peripheral wall portion 18 is built so as to surround the circumference. The peripheral wall portion 18 plays not only a role to protect the components mounted in the respective mounting holes 14a to 14q and enhance strength of the operation panel 10 but also a role as a base when fitted to a chassis of the multifunction device 30. In addition, at both left and right sides of the component mounting surface 14, cutout grooves 19 cut out in rectangular forms are formed.

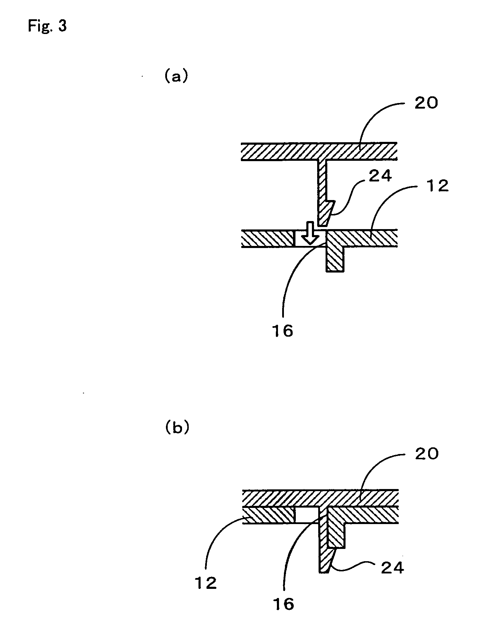

Theplatemember 20 is formed ina size to cover the component mounting surface 14 of the base member 12, and has exposing holes 20a to 20q to expose the respective components outside at positions opposed to all mounting holes 14a to 14q. of these exposing holes 20a to 20q, the exposing holes 20f provided atpositions opposed to the lamp mounting holes 14e have lenses fitted therein, though not illustrated, and the exposing hole 20g provided at a position corresponding to the speaker mounting hole 14g is formed as a group of pores. The plate member 20 has fitting projections 22 to be fitted with the cutout grooves 19 on the component mounting surface 14 at both left and right sides. The plate member 20 also has a plurality of hooks 24 along the circumference of the rear surface, and when the plate member 20 is integrated with the base member 12, these hooks 24 are latched and held on hook latching holes 16 formed on the component mounting surface 14, Conditions before and after the hooks 24 are inserted into the hook latching holes 16 are shown in Figs. 3.

Next, procedures for assembling the operation panel 10 will be described. The base member 12 is first prepared, and components are mounted in all mounting holes 14a to 14q of this base member 12. Next, the plate member 20 provided with the exposing holes 20a to 20q to expose components outside at positions opposed to the mounting holes 14a to 14q in which the components have been mounted is prepared, and the plate member 20 is integrated with the base member 12 by covering the component mounting surface 14 with the plate member 20 and fitting the respective hooks 24 into the respective hook latching holes 16. When the plate member 20 is integrated with the base member 12, the fitting projections 22 and 22 of the plate member 20 are fitted into the cutout grooves 19 of the component mounting surface 14. In this condition, when the fitting projections 22 and 22 are held down by holding members 28 from the upside, it becomes possible to fix the plate member 20 so as not to come off the base member 12.

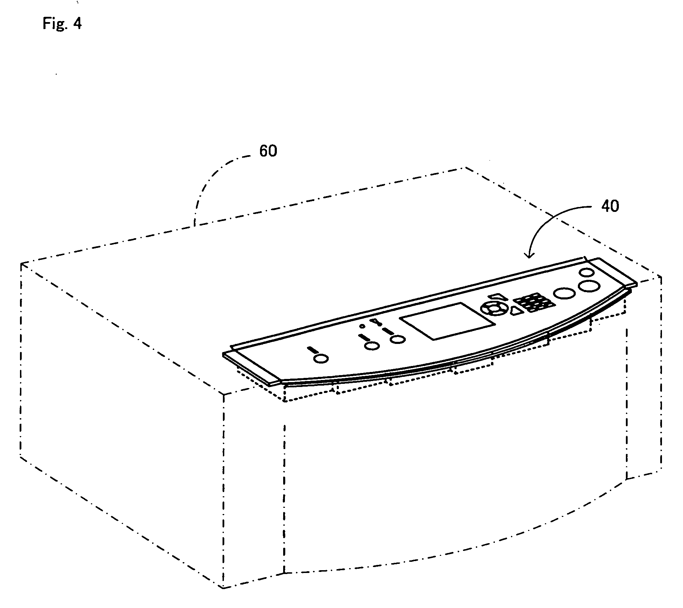

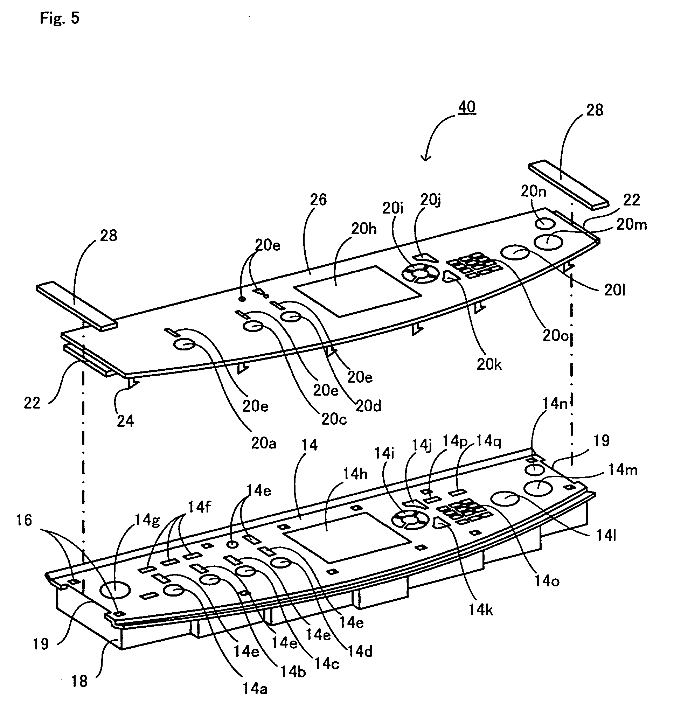

Next, a multifunction device 60 with a simplified function will be described. Fig. 4 is a schematic perspective view of the multifunction device 60, and Fig. 5 is a perspective assembly drawing of an operation panel 40 for the multifunction device 60. The operation panel 40 is, as shown in Fig. 4, to be fitted to the multifunction device 60 provided with respective functions as a scanner, a printer, and a copier, that is, the multifunction device 60 in which a facsimile function has been omitted. The operation panel 40 is formed by integrating a resin-made thick base member 12 molded by a metal mold with a resin-made plate-like thin-walled plate member 26 similarly molded by a metal mold, as shown in Fig. 4.

Since the base member 12 is a member common to that used in the foregoing operation panel 10, here the same symbols are used for the same elements and description thereof will be omitted. However, instead of mounting components in all fitting holes 14a to 14q, components related to the facsimile function are not mounted. In other words, one-touch dial buttons, a fax button, a speaker, an abbreviation button, and a redial button are not mounted in the dial mounting holes 14f, fax button mounting hole 14b, speaker mounting hole 14g, abbreviation button mounting hole 14p, and redial button mounting hole 14q, respectively.

Since the plate member 26 is the same in construction as the foregoing plate member 20 except for that the number of exposing holes is different, the same symbols are used for the same elements and description thereof will be omitted. In the plate member 26, the exposing holes 20a, 20c to 20e, and 20h to 20o to expose respective components outside are provided at positions opposed to the mounting holes 14a, 14c to 14e, and 14g to 14o in which the components have been mounted. Here, since integration of the plate member 26 with the base member 12 is the same as the integration of the plate member 20 with the base member 12, description thereof will be omitted.

Next, procedures for assembling the operation panel 40 will be described. The base member 12 is first prepared, components are mounted in mounting holes 14a, 14c to 14e, and 14g to 14o of the base member 12, and other mounting holes 14b, 14f, 14p, and 14q are left vacant without mounting components therein. Next,the plate member 26 provided with the exposing holes 20a, 20c to 20e, 20g to 20o to expose components outside at positions opposed to the mounting holes 14a, 14c to 14e, and 14g to 14o in which the components have been mounted is prepared, and the plate member 26 is integrated with the base member 12 by covering the component mounting surface 14 with the plate member 26 and fitting the respective hooks 24 into the respective hook latching holes 16. When the plate member 26 is integrated with the base member 12, the fitting projections 22 and 22 of the plate member 20 are fitted into the cutout grooves 19 and 19 of the component mounting surface 14. In this condition, when the fitting projections 22 and 22 are held down by holding members 28 from the upside, it becomes possible to fix the plate member 26 so as not to come off the base member 12:

According to the embodiment described above in detail, when components have been mounted in all mounting holes 14a to 14q of the base member 12, the plate member 20 provided with the exposing holes 20a to 20q at positions opposed to all mounting holes 14a to 14q is integrated with the base member 12 as in the operation panel 10, and when components have been mounted in some mounting holes 14a, 14c to 14e, and 14g to 14o of the base member 12, the plate member 26 provided with the exposing holes 20a, 20c to 20e, and 20g to 20o at positions opposed to 14a, 14c to 14e, and 14g to 14o is integrated with the base member 12 as in the operation panel 40. The above constructions of the operation panel 10 and the operation panel 40 have the base member 12 in common, and it requires exchange of only the plate member provides to prepare the operation panel 10 and the operation panel 40. Thus, manufacturing costs of the operation panel can be kept low.

The plate member 20 is an all component-compliant plate (optional function-compliant plate) provided with the exposing holes 20a to 20q at positions opposed to each of the mounting holes 14a and 14q, while the plate member 26 is a partial component-compliant plate (basic function-compliant plate) provided with exposing holes at positions opposed to some of the plurality of mounting holes 14a to 14q. It becomes possible to manufacture multiple types of operation panels 10 and 40 by only selecting either of these.

It is relatively easy to manufacture multiple types of plate members since the plate members 20 and 26 have plate-like forms., and, on the other hand, it costs more to manufacture multiple types of base member 12, which is thick. It is significant to provide the base member 12 as a common component. This is more prominent in the case of molding by a metal mold.

The base material 12 has the cutout grooves 19 at its peripheral edges and the plate members 20 and 26 have fitting projections 22 that are fitted into the cutout grooves 19 when being integrated with the base member 12. When the operation panels 10 and 40 are mounted on the multifunction devices 30 and 60, the plate members 20 and 26 can be prevented from coming off from the base member 12 by holding down the plate members 20 and 26 by the holding members 28 from the upside of the fitting projections 22.

The above embodiment is be considered in all aspects as illustrative and not restrictive. There may be many modifications, changes, and alterations without departing from the scope or spirit of the main characteristics of the present invention.

In the above embodiment, a description has been given of the operation panel 10 used for the multifunction device 30 and the operation panel 40 used for the multifunction device 60. It may also be possible to manufacture of operation panels of single-function printers, faxes, and scanners by using the base member 12 as a common component and plate members as different components, and integrating both.

It may be possible to print names or icons of buttons and the like exposed from the respective exposing holes, in the vicinity of the exposing holes of the plate members 20 and 26. Even in the case of such printing, printing can be easily carried out since the plate members 20 and 26 are thinner-walled than the base member 12. Here, a language suitable for the country in which the device is soled may be employed for the names.

With respect to the plate members 20 and 26 of the above-described embodiment, it may be possible to manufacture types with different colors and types with different patterns. This allows selection of an operation panel with a color or pattern according to the user's taste.

In the above embodiment, a description has been given on the assumption that the three functions as a scanner, a printer, and a copier on the multifunction device 60 are equivalent to the basic function and the facsimile function on the multifunction device 30 is equivalent to the optional function. It may be possible to provide the basic function as at least one of the functions as a scanner, a copier, and a fax, or to provide the basic function as a monochrome printing function, and the optional function, as a color printing function.

The present invention claims the benefit of priority from Japanese Patent Application No. 2005-071973 filed on March 14, 2005; and Japanese Patent Application No. 2006-000812 filed on January 5, 2006, the contents of which are incorporated herein by reference in their entirety.

## Claims

1. An operation panel that is used when operating an electronic control apparatus, comprising:
a base member that has first component mounting holes capable of mounting components to be exposed on an outer surface of the panel out of components used for a setting or operation of a basic function and second component mounting holes capable of mounting components to be exposed on the outer surface of the panel out of components used for a setting or operation of an optional function added to the basic function; and
a plate member that is integrated with the base member so as to cover an operating surface side of the base member and is provided with exposing holes at least at positions opposed to the first component mounting holes.

2. The operation panel according to Claim 1, wherein the plate member is selected from a basic function-compliant plate member having exposing holes only at positions opposed to the first component mounting holes and an optional function-compliant plate member having exposing holes both at positions opposed to the first component mounting holes and at positions opposed to the second component mounting holes.

3. An operation panel that is used when operating an electronic control apparatus, comprising:
a base member that has a component mounting surface provided with a plurality of mounting holes for mounting all types of components, where components have been mounted in some of the plurality of mounting holes; and
a plate member that is integrated with the base member so as to cover the component mounting surface and is provided with exposing holes to expose the components outside at positions opposed to mounting holes in which the components have been mounted.

4. The operation panel according to Claim 3, wherein the plate member is selected from an all component-compliant plate provided with the exposing holes at positions opposed to each of the mounting holes and a partial component-compliant plate provided with the exposing holes at positions opposed to some of the plurality of mounting holes.

5. The operation panel according to any of Claims 1 to 4, wherein the plate member is formed in a plate-like shape, and the base member is thicker than the plate member.

6. The operation panel according to any of Claims 1 to 5, wherein the plate member and the base member are mold products.

7. The operation panel according to any of Claims 1 to 6, wherein the base member has cutout grooves at peripheral portion, and the plate member has fitting projections that are fitted into the cutout grooves when being integrated with the base member.

8. The operation panel according to any of Claims 1 to 7, wherein information concerning components exposed from the exposing holes is printed in the vicinity of the exposing holes of the plate member.

9. An electronic control apparatus comprising the operation panel according to any of Claims 1 to 8.

10. A manufacturing method for an operation panel to be fitted to a chassis of an electronic control apparatus, comprising the steps of:
(a) preparing a base member that has first component mounting holes capable of mounting components to be exposed on an outer surface of the panel out of components used for a setting or operation of a basic function and second component mounting holes capable of mounting components to be exposed on the outer surface of the panel out of components used for a setting or operation of an optional function added to the basic function, and mounting components in only the first component mounting holes or mounting components in both the first and second component mounting holes; and
(b) selecting either plate member according to the components mounted in the step (a) of a basic function-compliant plate member having exposing holes only at positions opposed to the first component mounting holes and an optional function-compliant plate member having exposing holes both at positions opposed to the first component mounting holes and at the positions opposed to the second component mounting holes, and covering an operating surface side of the base member with the selected plate member so as to integrate the plate member with the base member.

11. A manufacturing method for an operation panel to be fitted to a chassis of an electronic control apparatus, comprising the steps of:
(a) preparing a base member that has a component mounting surface provided with a plurality of mounting holes for mounting all types of components, and mounting components in all or some of the plurality of mounting holes; and
(b) preparing a plate member that is provided with exposing holes to expose the components outside at positions opposed to mounting holes in which the components have been mounted and is provided with no exposing holes at positions opposed to vacant mounting holes, and covering the component mounting surface with the plate member so as to integrate the plate member with the base member.
